# EUROPÄISCHE PATENTSCHRIFT

(11) **EP 0 697 769 B1**
(45) Veröffentlichungstag und Bekanntmachung des Hinweises auf die Patenterteilung: **31.03.1999**
(21) Anmeldenummer: 95111347.1
(22) Anmeldetag: 19.07.1995
(51) Int. Cl.: H03K 17/95, G01V 3/10

(54) **Magnetischer Näherungsdetektor**
Magnetic proximity detector
Détecteur de proximité magnétique

(30) Priorität: 01.08.1994 DE 4427220
(43) Veröffentlichungstag der Anmeldung: 21.02.1996
(73) Patentinhaber: SIEMENS AKTIENGESELLSCHAFT, 80333 München (DE)
(72) Erfinder: Cuylen, Michael, D-90513 Zirndorf (DE); Stecher, Werner, Dipl.-Ing. (FH), D-91183 Abenberg (DE)

(56) Entgegenhaltungen:
- EP-A- 0 393 359
- DE-A- 2 831 598
- DE-A- 3 244 507
- MACHINE DESIGN, Bd. 54, Nr. 11, Mai 1982 CLEVELAND US, Seiten 195-212, 'Transducers'
- TIETZE & SCHENK: "Electronic Circuits, p.409-411" , 1991, SPRINGER-VERLAG, BERLIN
- TIETZE & SCHENK: "Electronic Circuits, p.409-411" , , SPRINGER-VERLAG, BERLIN

## Beschreibung

Die Erfindung bezieht sich auf einen magnetischen Näherungsdetektor.

Aus der DE 28 31 598 ist eine Vorrichtung zur Weg- und Geschwindigkeitsmessung eines metallischen Körpers bekannt, der auf einer Spur Weginkremente mit definierten Aussparungen aufweist. Diese laufen an einer Spulenanordnung vorbei, welche Bestandteil eines Oszillators ist. Hierdurch wird die Amplitude der Oszillatorschwingung in Abhängigkeit von der Zahnteilung des metallischen Körpers moduliert. Eine angeschlossene Auswerteschaltung liefert ein vom Vorzeichenwechsel des Modulationshubes der Oszillatorschwingung abhängiges Ausgangssignal.

Aus der DE 42 32 426 Al ist ferner eine "Schaltung zur induktiven Distanzerfassung eines Metallteiles" bekannt. Dabei wird eine Schaltung als bekannt vorausgesetzt, welche einen Oszillator aus einem Parallel-Resonanzkreis, einem Verstärker und einem Widerstand umfaßt. Der Resonanzkreis enthält als induktiven Aufnehmer eine Spule, in deren Magnetfeld das distanzvariierende Metallteil angeordnet ist. Diese Schaltung ist so erweitert, daß der Resonanzkreis bei großen Distanzen zwischen Metallteil und Spule nur wenig bedämpft und selbst bei einer Distanz 0 noch schwingt. Die Oszillatorschwingung soll also keinesfalls abreißen, so daß ein maximaler Distanzvariationsbereich mit intakter Amplitudenmodulation zur Verfügung steht. Um dies zu erreichen, wird der Verstärker mit einem Komparator rückgekoppelt. Die erwünschte Amplitude der Schwingung des Oszillators kann dabei mit einem im Rückkopplungskreis befindlichen Widerstand eingestellt werden.

Eine Spule der oben genannten Art ist aus der DE 32 41 018 bekannt und wird z.B. von der Firma VAC Vacuumschmelze, dort als ein sogenannter Positionssensor bezeichnet, z.B. unter den Produktkennzeichnungen MSE 582/024 oder MSE 582/011 angeboten.

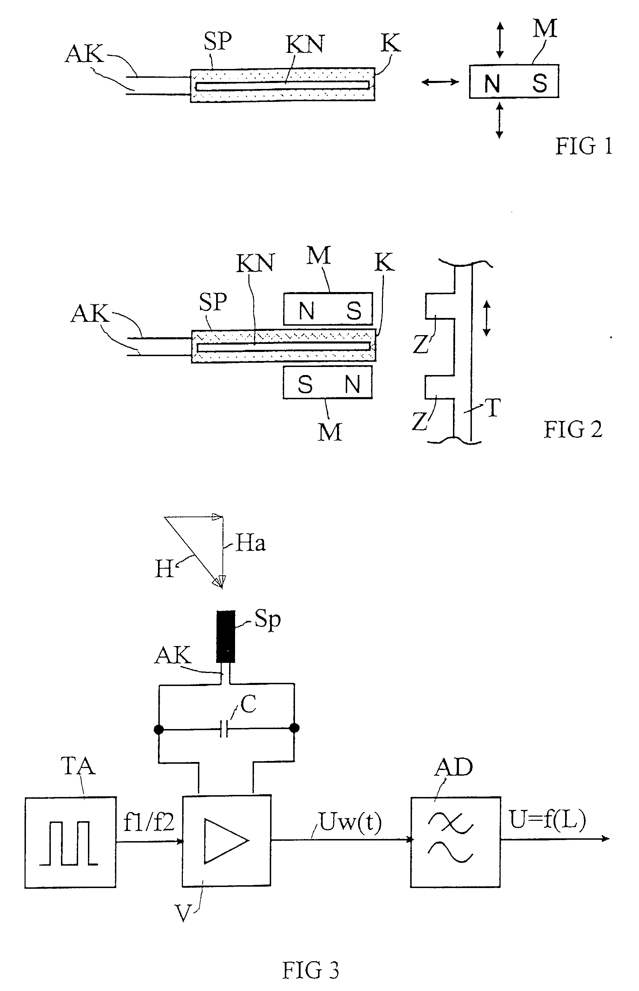

In den Figuren 1 und 2 sind beispielhaft eine derartige Spule und zwei verschiedene Möglichkeiten externer Einwirkung auf die Spule dargestellt. Die Spule SP enthält einen Kern KN aus weichmagnetischem Material, und kann über zwei Anschlußkontakte AK erregt werden. Der Spulenkern KN nimmt bei einer ausreichenden Annäherung eines Objektes bevorzugt im Bereich der Kopfseite K einen gesättigten Zustand an. Im Beispiel der Figur 1 wird hierzu ein Ansteuermagnet M aus einer beliebigen Raumrichtung kommend bis zum Erreichen des Wirkungsabstandes angenähert. Der Ansteuermagnet M kann dabei auf einem beliebigen, als Träger dienenden, in Figur 1 nicht dargestellten Objekt angebracht sein. Die Spule kann in einer derartigen Ausführung bevorzugt als Näherungsdetektor eingesetzt werden.

In Figur 2 ist eine weitere Ausführungsform dargestellt. Dabei ist die Spule (SP) bevorzugt im Bereich der Kopfseite K an den Seiten mit beispielhaft zwei Ansteuermagneten M versehen. In diesem Fall wird zur Erzeugung des gesättigten Zustandes ein aus ferromagnetischem Material bestehendes Objekt T angenähert. Dieses hat in dem Beispiel der Figur 2 die Form einer Zahnstange bzw. eines Zahnrades, dessen mit Zähnen Z besetzte Seite bevorzugt tangential an der Kopfseite K der Spule SP entlang geführt wird. Die Anordnung wird dabei vorteilhaft so dimensioniert, daß in der Spule bei Annäherung eines Zahnes Z der gesättigte Zustand erreicht wird, während die Spule bei Annäherung einer dazwischen liegenden Lücke in den ungesättigten Zustand zurückkehrt. Eine derartige Anordnung kann als Linearpositionssensor, Winkellagesensor oder Geschwindigkeitssensor dienen, in dem über den in Figur 2 dargestellten Näherungsdetektor die pro Zeiteinheit vorbei laufenden Zähne gezählt werden.

Von dem durch den beweglichen Ansteuermagneten in Figur 1 bzw. dem mindestens einen ortsfesten Ansteuermagneten in Figur 2 hervorgerufenen Vektor der magnetischen Feldstärke H wirkt auf die Spule SP die parallel zur Spulenachse verlaufende Komponente Ha des Feldstärkevektors H ein. Dies ist im oberen Bereich der Figur 3 dargestellt. Bei ausreichender Größe dieser Komponente Ha, z.B. bedingt durch eine ausreichende Annäherung eines Ansteuermagneten M gemäß Figur 1 bzw. eine ausreichende Annäherung eines ferromagnetischen Objektes T gemäß Figur 2 wird die sogenannte Sättigungsfeldstärke überschritten und der Kern KN nimmt den gesättigten Zustand an. Die Induktivität L der Spule SP geht dabei sprungartig auf einen relativ niedrigen Wert zurück. Dieser Übergang, und damit einer der oben beschriebenen Annäherungsereignisse, kann mit einer an die Anschlußkontakte der Spule angeschlossenen Ansteuer- und Auswerteschaltung erfaßt werden.

Bekannte Ansteuer- und Auswerteverfahren beruhen auf der unipolaren Impulsstrommethode, der bipolaren Impulsmethode bzw. der Wechselstrommethode. Bei den ersten beiden Methoden wird der Kern durch in die Spule eingespeiste unidirektionale oder bidirektionale Stromimpulse in die Sättigung gefahren. Die bei Abschalten eines derartigen Stromimpulses induzierte Spannung ist dann ein Maß für die Vormagnetisierung des Kerns und somit ein Maß für die Größe eines z.B. durch eine der oben beschriebenen Annäherungen hervorgerufenen bzw. beeinflußten externen Magnetfeldes. Bei der Wechselstrommethode wird die Schaltschwelle entweder durch die Amplitude des eingespeisten Wechselstromes oder durch die Größe eines dem Wechselstrom zusätzlich überlagerten Gleichstromes bestimmt. Die praktische Umsetzung eines dieser Ansteuer- und Auswerteverfahren hat in der Regel schaltungstechnisch aufwendige Anordnungen zur Folge, bei denen in der Regel zusätzliche Maßnahmen zumindest zur Stabilisierung gegenüber unerwünschten Temperaturdriftungen wesentlicher elektrischen Größen vorgesehen werden müssen.

Aus der DE 32 44 507 ist ein magnetfeldabhängiger induktiver Näherungsschalter bekannt. Dieser enthält eine Spulenanordnung mit einem ferromagnetischen Kern, der sättigungsempfindlich gegenüber dem zu erfassenden Magnetfeld ist, und eine elektronische Auswerteschaltung zur Auslösung eines Schaltvorganges bei einer bestimmten Kernsättigung. Die Spulenanordnung ist dabei das induktive Glied einer Hochfrequenz - Oszillatorschaltung. Dabei ist deren Schwingungsamplitude vom Grad der Kernsättigung abhängig, welche bei Unterschreiten eines Amplitudenwertes den Schaltvorgang auslöst.

Demgegenüber liegt der Erfindung die Aufgabe zugrunde, einen Näherungsdetektor anzugeben, der leicht den Randbedingungen angepasst werden kann, aber bezüglich Ansprechempfindlichkeit und Meßgenauigkeit eine zumindest ebenso effektive Ansteuerung und Auswertung ermöglicht.

Die Aufgabe wird gelost mit der im Anspruch 1 angegebenen Vorrichtung. Vorteilhafte weitere Ausführungsformen derselben sind in den nachfolgenden Unteransprüchen angegeben.

Der Detektor gemäß der Erfindung enthält als einen magnetischen Teil eine Spule, welche einen aus einem bevorzugt besonderen weichmagnetischem Material bestehenden Kern aufweist. Der Spulenkern nimmt bei Annäherung eines Ansteuermagneten einen gesättigten Zustand an. Ist die Spule bei einer weiteren Ausführung mit mindestens einem Ansteuermagneten versehen, so nimmt der Kern bei Annäherung eines Objektes aus ferromagnetischem Material ebenfalls einen gesättigten Zustand an. Durch den Übergang vom ungesättigten in den gesättigten Zustand fällt der Wert der Spuleninduktivität von einem normal großen auf einen relativ niedrigen Wert. Diese sprungartige Induktivitätsveränderung kann benutzt werden, um eine der oben beschriebenen Annäherungen zu detektieren.

Die Erfindung und die vorteilhaften Ausführungsformen derselben werden anhand der nachfolgend kurz dargestellten Figuren näher erläutert. Dabei zeigt
- Fig.1.: eine oben bereits beschriebene erste Variante für eine Spule mit externer Einwirkung über einen beweglichen Ansteuermagneten,
- Fig.2.: eine oben bereits beschriebene zweite Variante für eine Spule mit externer Einwirkung über ein bewegliches Objekt aus ferromagnetischem Material,
- Fig.3.: ein Blockschaltbild für den Aufbau des magnetischen Näherungsdetektors gemäß der Erfindung,
- Fig.4a bis 4c: die Verläufe der magnetischen Feldstärke und der Induktivität in der erfindungsgemäßen Vorrichtung für unterschiedliche Arbeitspunkte der Spule im ungesättigten und gesättigten Zustand, und
- Fig.5a: die bei erfindungsgemäßer Ansteuerung im sogenannten ungesättigten Resonanzpunkt im Verlauf der Amplitude der Meßwechselspannung auftretenden Arbeitspunkte AP1 und AP2 des Näherungsdetektors, und
- Fig.5b: die bei erfindungsgemäßer Ansteuerung im sogenannten gesättigten Resonanzpunkt im Verlauf der Amplitude der Meßwechselspannung auftretenden Arbeitspunkte AP1' und AP2' des Näherungsdetektors.

In Figur 3 ist in der Art eines Blockschaltbildes der Aufbau des erfindungsgemäßen magnetischen Näherungsdetektors dargestellt. Die in den Figuren 1 und 2 im Detail dargestellte Spule ist mit einem Kondensator C und einem Verstärker V, der zur Anregung dient, zu einem Parallelschwingkreis zusammengeschaltet. Der Verstärker V wird erfindungsgemäß bei einer Frequenz fl bzw. f2 betrieben, die entweder im ungesättigten oder im gesättigten Zustand annähernd den Resonanzzustand des Parallelschwingkreises hervorruft. Bevorzugt werden dem Verstärker V diese Anregungsfrequenzen fl bzw. f2 über einen vorgeschalteten Taktgenerator TA vorgegeben. Am Ausgang des Verstärkers V wird eine hochfrequente Meßwechselspannung Uw(t) abgegeben und von einem nachfolgenden Detektor AD weiter verarbeitet. Der Detektor AD bildet aus der Meßwechselspannung Uw(t) am Ausgang des Verstärkers V eine Größe U=f(L), deren Wert bei einer der oben beschriebenen Annäherungen einer möglichst starken Veränderung unterworfen wird. Vorteilhaft entspricht diese Größe dem Amplitudenverlauf der Meßwechselspannung Uw(t). Deren Amplitude weist einen vom Erregungszustand des Parallelschwingkreises abhängigen Wert auf, d.h. hat bei Resonanz einen hohen und ansonsten einen niedrigen Wert.

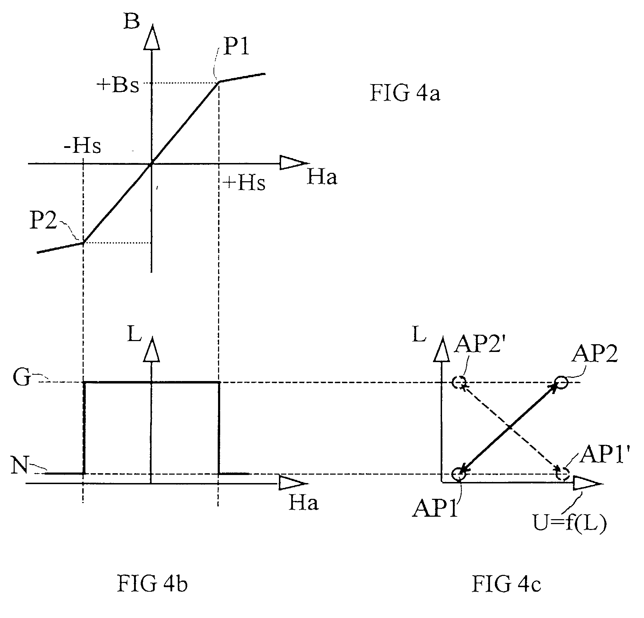

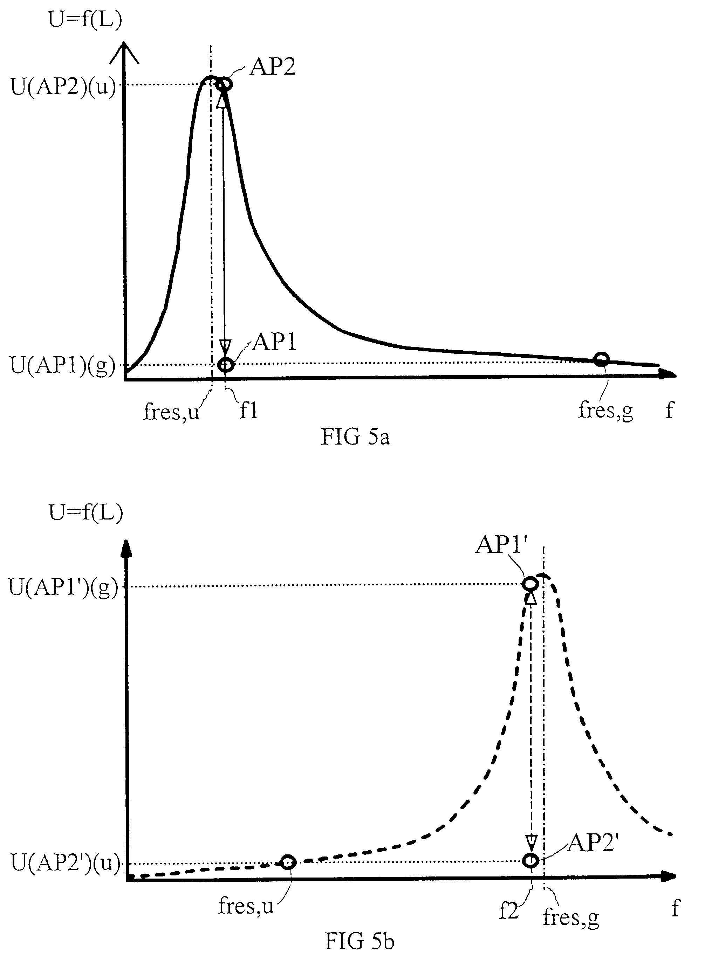

Die Funktionsweise der erfindungsgemäßen Vorrichtung wird desweiteren an Hand der in den Figuren 4a bis 4c und 5a, 5b näher erläutert.

In Figur 4a ist der Verlauf der magnetischen Induktion B in der Spule SP gegenüber der wirksamen, mit der Spulenachse parallelen Komponente Ha der Feldstärke eines äußeren magnetischen Feldes dargestelllt. Dabei befindet sich der Spulenkern KN im steilen Kurvenbereich zwischen den Werten -Bs und +Bs bzw. +Hs und -Hs im normalen, ungesättigten Zustand. Dies hat gemäß der darunter befindlichen Figur 4b eine Induktivität L der Spule SP mit einem normal großen Wert L zur Folge. In den Knickpunkten P1 und P2 der Magnetisierungskurve werden die Bereiche des positiven bzw. negativen Sättigungszustandes erreicht. Gemäß der darunter befindlichen Figur 4b hat dies eine Induktivität L der Spule SP mit einem relativ niedrigen Wert N zur Folge. Diese sprungartigen Veränderungen des Induktivitätswertes werden von einer der oben beschriebenen Annäherungen hervorgerufen, und können mit Hilfe nachfolgender Schaltungselemente im Sinne einer Näherungsdetektion erfaßt werden.

Dabei gibt es im wesentlichen zwei Möglichkeiten, die erfindungsgemäße Vorrichtung zu betreiben.

Bei einer ersten, in Figur 5a dargestellten Ausführungsform, wird der Verstärker V bei einer ersten Anregungsfrequenz fl betrieben. Diese ist annähernd identisch einer Frequenz fres,u , bei welcher der Parallelschwingkreis dann in Resonanz ist, wenn die Spule sich im ungesättigten Zustand befindet, d.h. eine der oben beschriebenen Annäherungen im Moment nicht vorliegt. In der Schaltung stellt sich somit bei Nichtvorliegen einer Annäherung gemäß der in Figur 5a dargestellten Resonanzkurve für den Amplitudenverlauf U=f(L) der Meßwechselspannung Uw(t) der annähernd mit dem Resonanzpunkt übereinstimmende Arbeitspunkt AP2 ein. Die Spannung am Ausgang des Detektors AD hat somit bedingt durch den dann normal großen Wert G der Spuleninduktivität L den relativ hohen Wert U(AP2)(u).

Ereignet sich nun eine der Annäherungen, so geht der Kern in den gesättigten Zustand über und der Wert der Spuleninduktivität L fällt gemäß Figur 4b auf einen relativ niedrigen Wert N. Die Spannung am Ausgang des Detektors AD fällt somit ebenfalls gemäß der Darstellung von Figur 5a auf einen relativ niedrigen Wert U(AP1)(g), und es stellt sich der neue Arbeitspunkt AP1 ein. Die Spannung hat einen Wert, welcher annähernd mit dem Amplitudenwert übereinstimmt, der auftreten würde, wenn die gesättigte Spule in der Nähe einer die Resonanz im Parallelschwingkreis hervorrufenden Frequenz betrieben werden würde. Ein damit vergleichbarer Punkt ist in Figur 5a am rechten Ende bei der dazugehörigen Resonanzfrequenz fres,g markiert. Der dort auftretende Amplitudenwert U(AP1)(g) ergibt, durch eine punktierte horizontale Linie nach links projiziert, im Schnittpunkt mit der vertikalen Arbeitsgeraden bei der aktuellen Anregungsfrequenz fl den nun aktuellen, zweiten Arbeitspunkt AP1 der Schaltung. Wird das die Sättigung hervorrufende Objekt wieder entfernt, d.h. der Annäherungszustand zumindest vorübergehend wieder beendet, so nimmt die Vorrichtung wieder den Arbeitspunkt AP2 ein.

Derartige Übergänge zwischen den Arbeitpunkten AP1 und AP2 sind auch in Figur 4c dargestellt, und können mit nachfolgenden, nicht dargestellten Schaltungen ausgewertet werden. Hieraus können Anzeige- und Schaltsignale erzeugt werden, welche abhängig sind vom Vorliegen oder dem Nichtvorliegen einer der oben beschriebenen Annäherungen. Es entsteht somit der erfindungsgemäße, sogenannte Näherungsdetektor, der wiederum Bestandteil z.B. einer Vorrichtung zur Erfassung einer Linear- oder Winkelposition sein kann.

Bei einer zweiten, in Figur 5b dargestellten Ausführungsform, wird der Verstärker V bei einer zweiten Anregungsfrequenz f2 betrieben. Diese ist annähernd identisch einer Frequenz fres,g , bei welcher der Parallelschwingkreis dann in Resonanz ist, wenn der Kern sich im gesättigten Zustand befindet, d.h. eine der oben beschriebenen Annäherungen im Moment vorliegt. In der Schaltung stellt sich somit bei Vorliegen einer Annäherung gemäß der in Figur 5b dargestellten Resonanzkurve für den Amplitudenverlauf U=f(L) der Meßwechselspannung Uw(t) der annähernd mit dem Resonanzpunkt übereinstimmende Arbeitspunkt AP1' ein. Die Spannung am Ausgang des Detektors AD hat dann trotz eines relativ niedrigen Wertes N der Spuleninduktivität L einen relativ hohen Wert U(AP1')(g). Dies ist auch an der Darstellung in Figur 4c zu erkennen.

Ereignet sich nun nach einer Annäherung wiederum eine "Entfernung", so geht der Kern in den ungesättigten Zustand über und der Wert der Spuleninduktivität L steigt gemäß Figur 4b auf einen normal großen Wert N. Die Spannung am Ausgang des Detektors AD fällt dann gemäß der Darstellung von Figur 5b auf einen relativ niedrigen Wert U(AP2')(u), und es stellt sich der neue Arbeitspunkt AP2' ein. Die Spannung hat einen Wert, welcher annähernd mit dem Amplitudenwert übereinstimmt, der auftreten würde, wenn die ungesättigte Spule in der Nähe einer die Resonanz im Parallelschwingkreis hervorrufenden Frequenz betrieben werden würde. Ein damit vergleichbarer Punkt ist in Figur 5b am linken Ende bei der dazugehörigen Resonanzfrequenz fres,u markiert. Der dort auftretende Amplitudenwert U(AP2')(u) ergibt, durch eine punktierte horizontale Linie nach rechts projiziert, im Schnittpunkt mit der vertikalen Arbeitsgeraden bei der aktuellen Anregungsfrequenz f2 den nun aktuellen, zweiten Arbeitspunkt AP2' der Schaltung. Wird das die Sättigung hervorrufende Objekt wieder angenähert, d.h. der Entfernungszustand zumindest vorübergehend wieder beendet, so nimmt die Vorrichtung wieder den Arbeitspunkt AP1' ein.

Derartige Übergänge zwischen den Arbeitpunkten AP1' und AP2' sind ebenfalls in Figur 4c dargestellt, und können mit nachfolgenden, nicht dargestellten Schaltungen ausgewertet werden. Hieraus können Anzeige- und Schaltsignale erzeugt werden, welche abhängig sind vom Vorliegen oder dem Nichtvorliegen einer der oben beschriebenen Annäherungen. Es entsteht somit der erfindungsgemäße, sogenannte Näherungsdetektor, der wiederum Bestandteil z.B. einer Vorrichtung zur Erfassung einer Linear- oder Winkelposition sein kann.

Falls es abhängig von weiteren Randbedingungen gewünscht ist, daß die erfindungsgemäße Schaltung möglichst wenige elektromagnetische Störungen abstrahlt, so kann für den Parallelschwingkreis als Anregungsfrequenz aus dem Wertepaar f1, f2 bevorzugt der im niedrigeren Frequenzbereich liegende Wert fl ausgewählt werden.

Erfindungsgemäß ist der Parallelschwingkreis folglich so ausgelegt, daß dieser aus dem Resonanzzustand herausgeführt wird, wenn im Falle einer Anregung mit fl gemäß Figur 5a ein Annäherungsvorgang, bzw. im Falle einer Anregung mit f2 nach Figur 5b ein Entfernungsvorgang stattfindet.

Gegenüber den oben beschriebenen, bekannten Ansteuer- und Auswerteverfahren beruht der die Ansteuer- und Auswerteschaltung betreffende Teil des erfindungsgemäßen Detektors somit auf der Anwendung eines Parallelschwingkreis-Resonanzverfahrens. Ein derartiger, auch als Resonanzsensor bezeichenbarer magnetischer Näherungsdetektor hat den besonderen Vorteil, daß ein von äußeren Störungen unbeeinflußter, stabiler Betrieb möglich ist, ohne daß die Elemente der Ansteuer- und Auswerteschaltung einen besonderen Aufwand erfordern. So kann der Verstärker V zur Anregung des Parallelschwingkreises bevorzugt in Form eines einfachen Operationsverstärkers ausgeführt werden. Ferner kann der Amplitudendetektor AD bevorzugt in Form eines auf die vom Taktgenerator vorgegebene Anregungsfrequenz dimensionierten Tiefpasses ausgeführt werden.

## Patentansprüche

1. Magnetischer Näherungsdetektor, mit entweder
a₁) einer Spule (SP) mit einem Kern (KN) aus weichmagnetischem Material, wobei der Kern (KN) bei Annäherung eines Ansteuermagneten (M) einen gesättigten Zustand annimmt, oder
a₂) einer mit mindestens einem Ansteuermagneten (M) versehenen Spule (SP) mit einem Kern (KN) aus weichmagnetischem Material, wobei der Kern bei Annäherung eines Objektes aus ferromagnetischem Material einen gesättigten Zustand annimmt,
und mit
b) einer Ansteuer- und Auswerteschaltung, mit
b1) einem Kondensator (C) und einem Verstärker (V), die mit der Spule (SP) einen Parallelschwingkreis bilden, wobei der Verstärker (V) zum wahlweisen Betrieb des Parallelschwingkreises bei einer von zwei Frequenzen (f1, f2), bei welcher sich der Parallelschwingkreis im ungesättigten bzw. im gesättigten Zustand des Kernes (KN) annähernd in Resonanz (fres, u; fres,g) befindet, durch Steuermittel (TA) mit dieser jeweiligen Frequenz (f1, f2) betrieben wird, und
b2) mit einem Detektor (AD), welcher aus einer Meßwechselspannung (Uw(t)) am Ausgang des Verstärkers (V) eine Größe (U=f(L)) bildet, deren Wert (U(AP2)(u), U(AP2')(u)) bei einer Annäherung eine möglichst starke Veränderung aufweist.

2. Näherungsdetektor nach Anspruch 1, wobei der Detektor (AD) die Amplitude der Meßwechselspannung (Uw(t)) als die bei einer Annäherung eine möglichst starke Veränderung aufweisende Größe (U=f(L)) verwendet.

3. Näherungsdetektor nach Anspruch 1 oder 2, wobei der Detektor (AD) einen Tiefpaß aufweist, dessen Grenzfrequenz kleiner als die Frequenz (f1, f2), bei welcher der Verstärker (V) betrieben wird, ist.

## Claims

1. Magnetic proximity detector with either
a1) a coil (SP) with a core (KN) of soft magnetic material, the core (KN) assuming a saturated state on the approach of a driving magnet (M), or
a2) a coil (SP) provided with at least one driving magnet (M) with a core (KN) of soft magnetic material, the core assuming a saturated state on the approach of an object of ferromagnetic material,
and with b) a driver and evaluation circuit, with
b1) a capacitor (C) and an amplifier (V), which form a parallel resonant circuit with the coil (SP), whereby at one of two frequencies (f1, f2), in which the parallel resonant circuit finds itself approximately in resonance (fres,u; fres,g) in the saturated or non-saturated state of the core (KN), the amplifier (V) for optional operation of the parallel resonant circuit is operated by control means (TA) with this respective frequency (fl, f2), and
b2) with a detector (AD), which from a measuring alternating voltage (Uw(t)) at the output of the amplifier (V) forms a quantity (U=f(L)), the value of which (U(AP2) (u), U(AP2')(u)) displays the strongest possible change on an approach.

2. Proximity detector according to claim 1, the detector (AD) using the amplitude of the measuring alternating voltage (Uw(t)) as the quantity (U=f(L)) displaying the strongest possible change in the event of an approach.

3. Proximity detector according to claim 1 or 2, the detector (AD) having a low pass, the cut-off frequency of which is smaller than the frequency (fl, f2) at which the amplifier (V) is operated.

## Revendications

1. Détecteur de proximité magnétique, comportant soit
a₁) une bobine (SP) qui a un noyau (KN) en un matériau magnétique doux, le noyau (KN) prenant un état saturé lorsqu'un aimant de commande (M) s'en rapproche, soit
a₂) une bobine (SP) qui est munie d'au moins un aimant de commande (M) et qui a un noyau (KN) en un matériau magnétique doux, le noyau (KN) prenant un état saturé lorsqu'un objet en un matériau ferromagnétique s'en rapproche,
et comportant
b) un circuit de commande et d'exploitation, comportant
b1) un condensateur (C) et un amplificateur (V) qui forment avec la bobine (SP) un circuit oscillant parallèle, l'amplificateur (V) étant commandé par des moyens de commande (TA), pour le fonctionnement du circuit oscillant parallèle au choix à l'une des deux fréquences (f1, f2) à laquelle le circuit oscillant parallèle se trouve approximativement en résonance (fres,u ; fres,g) à l'état non saturé ou à l'état saturé du noyau (KN), et
b2) un détecteur (AD) qui forme à partir d'une tension alternative de mesure (Uw(t)) à la sortie de l'amplificateur (V) une grandeur (U = f(L)) dont la valeur (U(AP2) (u), U(AP2')(u)) présente la variation la plus grande possible lors d'un rapprochement.

2. Détecteur de proximité selon la revendication 1, dans lequel le détecteur (AD) utilise l'amplitude de la tension alternative de mesure (Uw(t)) comme grandeur (U = f(L)) présentant la variation la plus grande possible lors d'un rapprochement.

3. Détecteur de proximité selon la revendication 1 ou 2, dans lequel le détecteur (AD) comporte un filtre passe-bas dont la fréquence limite est inférieure à la fréquence (f1, f2) à laquelle l'amplificateur (V) fonctionne.
